# FASCICULE DE BREVET EUROPEEN

(11) **EP 0 531 242 B1**
(45) Date de publication et mention de la délivrance du brevet: **30.07.1997**
(21) Numéro de dépôt: 92460026.5
(22) Date de dépôt: 03.09.1992
(51) Int. Cl.: H03H 17/02

(54) **Procédé de filtrage adapté d'un signal transformé en sous-bandes, et dispositif de filtrage correspondant**
Adaptives Filterverfahren eines in Teilbändern transformierten Signals und entsprechende Filteranordnung
Adaptive filtering method of a signal transformed in subbands and corresponding filter device

(30) Priorité: 03.09.1991 FR 9111029
(43) Date de publication de la demande: 10.03.1993
(73) Titulaire: FRANCE TELECOM, 75015 Paris (FR); TELEDIFFUSION DE FRANCE, 75932 Paris Cédex 15 (FR)
(72) Inventeur: Mau, Joel, F-35000 Rennes (FR)
(74) Mandataire: Corlau, Vincent

(56) Documents cités:
- EP-A- 0 065 210
- IEEE 1983 INT. SYMP. ON CIRC. AND SYSTEMS 2-5 MAY 1983; NEWPORT BEACH, US, E. LUEDER: DESIGN AND OPTIMIZATION OF DIGITAL FILTERS WITHOUT MULTIPLIERS, P. 1336-1339

## Description

Le domaine de l'invention est celui du filtrage de signaux numériques. Plus précisément, l'invention concerne un nouveau procédé de filtrage de signaux numériques transformés en sous-bandes.

En traitement du signal, il est courant de transformer un signal source du domaine temporel dans le domaine des fréquences. Une telle transformation présente de nombreux avantages. Elle permet en effet le plus souvent de concentrer l'énergie du signal sur un nombre réduit de coefficients, et d'effectuer divers traitements fonction de l'application, tenant compte par exemple de critères psychovisuels ou psychoacoustiques, de critères de débit maximum, etc...

Ces techniques de transformation trouvent donc des applications dans de nombreux domaines. Elles peuvent ainsi permettre la réduction du débit d'un signal sonore numérique, en vue de sa diffusion (par exemple du type DAB : Digital Audio Broadcasting) ou de son stockage, par exemple sur disques optiques ou sur supports magnétiques. Elles s'appliquent également à la réduction du débit d'images fixes ou animées, par exemple pour la télévision 4.2.2, télévision haute définition, la télévision numérique de terre (DNT: Diffusion Numérique de Terre), la visiophonie, les télécopies, etc ... et pour le stockage des images. Une autre application est encore la conversion de formats d'images.

Plus généralement, de telles techniques sont également utilisées pour réaliser des changements de représentation du signal, des multiplexages et des démultiplexages dans le traitement de signaux radar, etc...

L'invention peut s'appliquer à tous ces domaines, et à bien d'autres.

Parmi les techniques de transformation connues, on distingue notamment les transformations par blocs, par exemple du type DCT (transformation en cosinus discret), FFT (transformation de Fourier rapide), DST (transformation en sinus discret), KLT (transformation de Karhunen et Loewe), etc..., et plus généralement les transformations par application d'un banc de filtres, tels que des filtres QMF (filtres miroir en quadrature), CQF (filtres en quadrature conjugués), PQMF (pseudo filtres miroir en quadrature), et bien d'autres bancs de filtres mettant en oeuvre aussi bien des RIF (filtres à réponse impulsionnelle finie) que des RII (filtres à réponse impulsionnelle infinie). De nombreux autres moyens de transformation sont également connus et compatibles avec le procédé de l'invention.

Un exemple d'une telle technique de transformation est connue du document EP-A-0 065 210.

D'un point de vue général, toutes ces transformations ont en commun le fait de transposer le signal source vers une représentation plus ou moins fréquentielle, tout en conservant tout de même un aspect spatial, la transformation se faisant localement dans le signal.

Par la suite, on regroupera toutes ces techniques, par souci de simplification et par extension, sous le terme générique de "transformation en sous-bandes". Ces transformations seront donc vues comme l'application d'un banc de filtres d'analyse suivi d'un sous-échantillonnage pour le sens de la transformation directe, et d'un sur-échantillonnage suivi d'un banc de filtres de synthèse et d'une addition de l'ensemble des sorties de ces filtres de synthèse dans le cas de la transformation inverse.

Après la transformation directe, la sortie sous-échantillonnée de chaque filtre sera désignée par le terme "sous-bande". Ce terme englobe bien sûr des sous-bandes délivrées par un banc de filtres, mais également tout type de signaux délivrés par une transformation quelconque, qui peuvent être considérés comme des sous-bandes, et notamment les signaux délivrés par une transformation par blocs, également appelés coefficients transformés.

L'intérêt de la décomposition en sous-bandes d'un signal repose notamment sur le fait que celles-ci sont échantillonnées à une fréquence inférieure à la fréquence d'échantillonnage du signal source. Il est clair qu'il est plus facile d'effectuer des traitements sur ces sous-bandes échantillonnées à fréquence réduite que sur le signal d'origine. Cela est d'autant plus vrai que, le plus souvent, seules certaines sous-bandes subissent un traitement particulier.

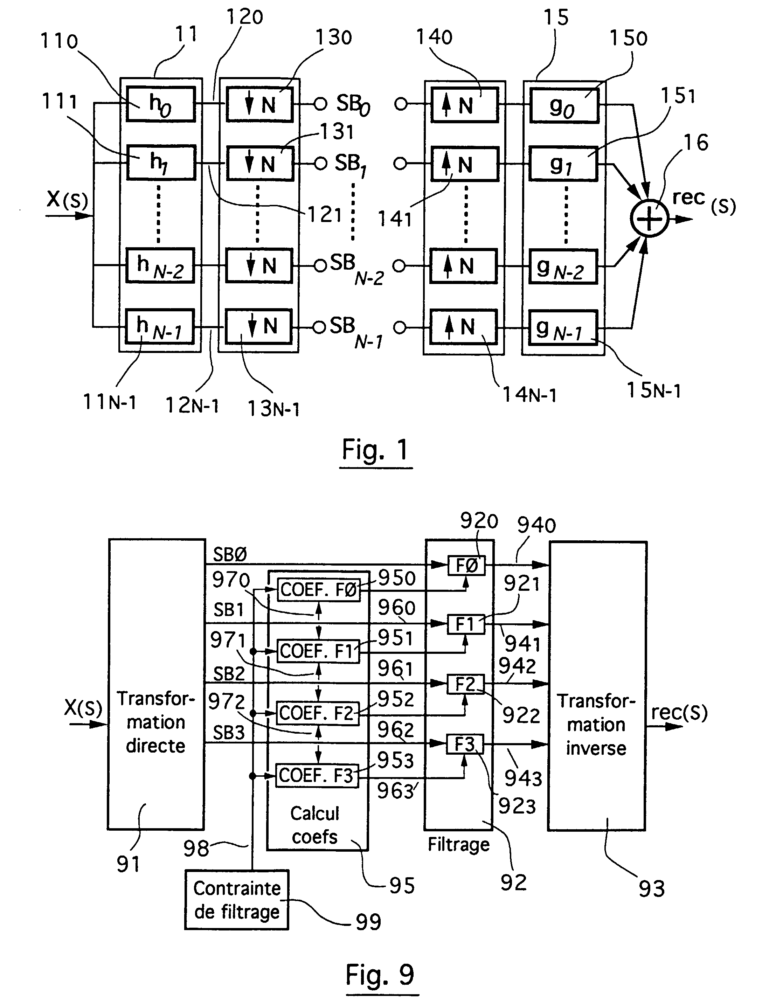

De façon classique, ainsi qu'on le verra plus en détail par la suite, en liaison avec les figures 1 à 8, le traitement des sous-bandes consiste simplement, selon les méthodes antérieures connues, en une multiplication de certaines des sous-bandes par un coefficient pondérateur donné. Cela permet de réduire, voire d'annuler, certaines des sous-bandes. On définit ainsi, de façon particulièrement simple, un filtre particulier pour le signal complet.

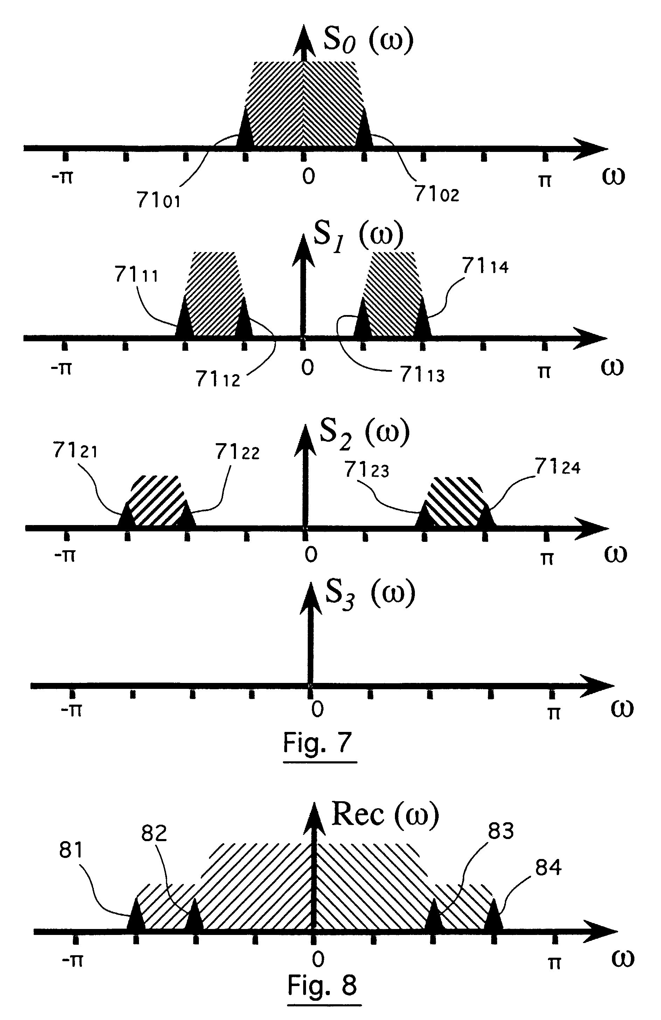

Toutefois, cette technique présente un inconvénient majeur. Lors de la reconstruction du signal, c'est-à-dire après l'atténuation de certaines sous-bandes, il apparaît des termes de "pollution" (voir par exemple figure 8, termes 81 à 84), dus au phénomène de repliement des spectres.

On a trouvé des techniques, rapidement décrites par la suite, qui permettent d'atténuer l'importance des repliements de spectres. Cependant, ces techniques se traduisent par un nombre plus élevé de termes de repliements de valeurs plus faibles.

Par ailleurs, les filtrages réalisés à l'aide de ces techniques connues sont souvent très sélectifs en fréquence, ce qui provoque des phénomènes de "rebonds" (en anglo-saxon : "ripples") autour des contours, notamment dans le cas du traitement d'images.

L'invention a notamment pour objectif de pallier ces différents inconvénients des procédés de filtrage en sous-bandes.

Plus précisément, un objectif de l'invention telle que définie par la revendication 1 est de fournir un procédé de filtrage d'un signal transformé en sous-bandes, permettant d'obtenir un signal reconstitué non, ou peu, perturbé par les repliements de spectres.

Un autre objectif de l'invention est de fournir un tel procédé de filtrage, qui autorise l'utilisation de très nombreux profils de filtrage d'une ou plusieurs sous-bandes, et notamment des profils des types passe-bas, passe-haut, passe-bande, réjecteur, multi-bande, accentuateur ou atténatueur de certaines bandes, etc...

L'invention a également pour objectif de fournir un tel procédé basé sur l'utilisation d'un jeu de filtres simples à mettre en oeuvre. Ainsi, un objectif de l'invention est de fournir un tel procédé de filtrage, qui soit aisément implantable, notamment sur circuit intégré. Un autre objectif particulier est donc de limiter fortement le nombre de multiplications nécessaires à la mise en oeuvre de ce procédé.

Un autre objectif de l'invention est de fournir un tel procédé, permettant de réaliser un filtrage adaptatif, pouvant varier à tout moment, par exemple en fonction d'une contrainte de débit maximum ou d'une information liée à l'analyse du signal à filtrer.

Un objectif particulier de l'invention est encore de fournir un tel procédé, permettant d'obtenir des profils de filtrage adoucis, n'introduisant pas de phénomènes d'ondulations de contours (en traitement de l'image) généralement provoqués par des filtres de décomposition en sous-bandes très sélectifs, comme par exemple les filtres PQMF.

L'invention a également pour objectif de fournir un tel procédé de filtrage, qui puisse s'appliquer à tous types d'applications, qu'il s'agisse du traitement du son ou de l'image (fixe ou animée), de multiplexage, de traitement de signaux multidimensionnels, etc... Un objectif particulier de l'invention est de fournir un tel procédé, permettant de réaliser des conversions de formats d'image, notamment d'images entrelacées, sans introduire de "saccades" dans l'image.

Un autre objectif de l'invention est bien sûr de fournir des dispositifs de filtrage, notamment sous forme de circuits intégrés, mettant en oeuvre un tel procédé.

Ces objectifs, ainsi que d'autres qui apparaîtront par la suite, sont atteints selon l'invention à l'aide d'un procédé de filtrage d'un signal numérique source, comprenant les étapes de :
- transformation du domaine temporel dans le domaine fréquentiel dudit signal numérique source, délivrant au moins deux sous-bandes de fréquence distinctes ;
- traitement de filtrage de chacune desdites sous-bandes de fréquence, incluant les étapes de :
   - définition d'un profil global de filtrage correspondant à un filtrage destiné à être appliqué audit signal numérique source ;
   - détermination d'un jeu de profils partiels de filtrage associés chacun à une desdites sous-bandes, lesdits profils partiels de filtrage étant déterminés à partir dudit profil global de filtrage ; et
   - filtrage de chacune desdites sous-bandes selon le profil partiel de filtrage qui lui est associé, ladite étape de filtrage associant à chacune desdites sous-bandes une sous-bande filtrée correspondante, ladite sous-bande filtrée présentant des repliements de spectre dus au filtrage selon ledit profil partiel de filtrage ; et
- transformation desdites sous-bandes filtrées inverse de ladite étape de transformation, du domaine fréquentiel dans le domaine temporel, délivrant un signal filtré reconstruit,
lesdits profils partiels de filtrage déterminés lors de ladite étape de détermination d'un jeu de profils partiels de filtrage étant contraints de façon que ledit signal filtré reconstruit corresponde sensiblement au filtrage direct dudit signal numérique source selon ledit profil global de filtrage.

De façon préférentielle, ladite étape de détermination d'un jeu de profils partiels de filtrage comprend, pour au moins un desdits profils partiels de filtrage, une étape de contrainte dudit profil partiel de filtrage en fonction d'au moins un de ses profils partiels de filtrage voisins dans le domaine des fréquences, contraignant ledit profil partiel de filtrage de façon que, lors de ladite étape de transformation inverse, les repliements de spectres restant après le filtrage selon ledit profil de filtrage lors de ladite étape de filtrage se compensent sensiblement avec les repliements de spectre restant après le filtrage selon ledit au moins un profil partiel de filtrage voisin.

En d'autres termes, selon l'invention, au moins un desdits profils de filtrage est contraint en fonction d'au moins un de ses profils de filtrage voisins dans le domaine des fréquences, de façon à maîtriser la conservation et/ou l'atténuation et/ou la suppression de repliements de spectres (inhérents à la technique de filtrage en sous-bandes) compensant sensiblement les repliements de spectres complémentaires conservés et/ou atténués et/ou supprimés par lesdits profils de filtrage voisins.

L'approche nouvelle proposée par l'invention repose ainsi sur le fait de modeler le profil d'une sous-bande donnée, en tenant compte du profil des sous-bandes voisines, de façon à limiter les repliements, lors de la reconstruction du signal (les termes de repliement se compensant alors).

Dans un mode de réalisation avantageux, ladite étape de contrainte contraint lesdits profils partiels de filtrage de façon que le spectre dudit signal reconstruit (rec(s)) soit continu.

De façon préférentielle, au moins un desdits profils partiels de filtrage contraints présente des tangentes sensiblement horizontales au voisinage desdites positions fréquentielles égales à 0 modulo π.

Cette contrainte des tangentes horizontales est une caractéristique importante de l'invention. Elle permet en effet de limiter sensiblement les repliements tout en autorisant des profils de filtrage variés.

De façon avantageuse, au moins un desdits profils partiels de filtrage est obtenu par combinaison linéaire de filtres appartenant à un jeu de filtres de base prédéfinis.

A l'aide d'une batterie de filtres de base simples connus, tels qu'un filtre identité et un filtre passe-bas, dans le cas de signaux monodimensionnels, il est en effet possible d'obtenir ainsi à faible coût une très grande diversité de filtres.

Préférentiellement, pour faciliter l'intégration du procédé dans des circuits intégrés, les coefficients multiplicateurs de ladite combinaison linéaire et lesdits filtres de base sont choisis de façon que les filtres soient implantables sans multiplication (en anglo-saxon : "multiplication less") à l'aide d'un jeu d'additions et de décalages binaires.

En d'autres termes, on choisit des coefficients simples (par exemple du type 2⁻ⁿ) qui permettent de réaliser la combinaison linéaire seulement à l'aide de décalages et d'additions.

Dans le cas d'un filtrage monodimensionnel, ces profils peuvent par exemple être obtenus à l'aide d'un filtre de coefficients [0,25 * α ; 0,5 * α + β ; 0,25 * α], α et β étant des paramètres réels, et avantageusement rationnels.

Préférentiellement, dans le cas d'un procédé mettant en oeuvre un banc de filtres d'analyse dans ladite étape de transformation et un banc de filtres de synthèse dans ladite étape de transformation inverse, lesdits filtres d'analyse et de synthèse sont très sélectifs. Par filtre sélectif, on entend un filtre ne générant de l'énergie parasite que, ou principalement, dans les sous-bandes voisines.

L'invention concerne également les dispositifs mettant en oeuvre ce procédé, réalisé notamment en circuit intégré.

L'invention s'applique à de nombreux domaines, et notamment :
- réduction du débit de signaux en son ;
- réduction du débit de signaux d'images fixes et/ou animées ;
- conversion de format de signaux d'images ou de sons ;
- changement de représentation de signaux ;
- multiplexage/démultiplexage de signaux ;
- traitement de signaux radar ;
- filtrage de signaux multidimensionnels.

D'autres caractéristiques et avantages de la présente invention apparaîtront à la lecture de la description suivante d'un mode de réalisation préférentiel, donné à titre illustratif et non limitatif, et des figures annexées, dans lesquelles :
- la figure 1 présente un schéma synoptique illustrant le principe général, connu en soi, de la transformation en sous-bandes, dans le cas particulier d'une transformation en N sous-bandes d'égales largeurs ;
- les figures 2 à 5 représentent les spectres des signaux source, après filtrage d'analyse, après sous-échantillonnage et après filtrage de synthèse respectivement, tels qu'ils se présentent aux différents niveaux du dispositif schématisé en figure 1, en l'absence de traitement de filtrage ;
- les figures 6 à 8 illustrent deux exemples de spectres filtrés selon l'art antérieur, correspondant à la mise à zéro d'une sous-bande (figure 6), et à la mise à zéro d'une sous-bande et à l'atténuation d'une sous-bande voisine (figures 7 et 8);
- la figure 9 est un schéma synoptique d'un dispositif de filtrage adapté selon l'invention ;
- les figures 10 à 12 illustrent un premier exemple de mise en oeuvre de l'invention, en présentant respectivement les spectres filtrés de façon adaptée, après sous-échantillonnage, les spectres obtenus après filtrage de synthèse et le spectre du signal reconstruit, présentant des repliements parasites nuls ou très fortement atténués ;
- les figures 13 et 14 présentent un second exemple de mise en oeuvre de l'invention, à profil de filtrage adouci, avec respectivement les spectres des sous-bandes filtrés selon l'invention et le signal reconstruit ;
- la figure 15 illustre le principe général du procédé de filtrage adapté selon l'invention ;
- les figures 16 à 20 illustrent une méthode de mise en oeuvre du critère des tangentes horizontales.

La figure 1 illustre le principe général connu de la transformation en sous-bandes. Le signal numérique source x(s) est introduit dans un banc de filtres 11, qui comprend une série de N filtres d'analyse 11₀ à 11_{N-1} (de réponse h₀ à h_{N-1}) traitant en parallèle le signal source x(s). Ces filtres d'analyse sont souvent de largeurs de bandes égales, mais cette condition n'est nullement obligatoire.

Par ailleurs, bien que décrite ici uniquement pour un signal monodimensionnel, cette technique peut bien sûr être généralisée à tous les signaux bidimensionnels et multidimensionnels.

Le banc de filtres 11 délivre donc une série de N signaux 12₀ à 12_{N-1}, à une fréquence d'échantillonnage fₛ égale à la fréquence du signal source x(s). Les bancs de filtres présentent la caractéristique très intéressante de fournir des sous-bandes à fréquence d'échantillonnage plus faible. On sait en effet que ceci est possible, avec une perte d'information significative minime (voire nulle, au moins en théorie) lorsque l'on passe d'un signal à la fréquence fₛ à N signaux en sous-bandes à la fréquence fₛ/N (dans le cas particulier décrit d'une transformation à N sous-bandes d'égales largeurs). Cette caractéristique s'avère particulièrement avantageuse lorsque seulement certaines des sous-bandes subissent un traitement particulier, ce traitement étant alors effectué à la fréquence fₛ/N, et non plus fₛ.

Pour réaliser ce changement de fréquence, chaque signal 12₀ à 12_{N-1} est sous-échantillonné d'un facteur N par un module (13₀ à 13_{N-1}) de sous-échantillonnage, dont les sorties délivrent N sous-bandes SB₀ à SB_{N-1}. Ce sont ces sous-bandes que l'invention se propose de filtrer.

La reconstruction du signal se fait de façon symétrique, à l'aide de N modules de suréchantillonnage 14₀ à 14_{N-1} ramenant chacune des sous-bandes SB₀ à SB_{N-1} à la fréquence d'origine fₛ et d'un banc de filtres 15, comprenant N filtres de synthèse 15₀ à 15_{N-1} (de réponse g₀ à g_{N-1}). Les signaux issus de ces filtres sont ensuite additionnés dans un sommateur 16, délivrant le signal reconstitué rec(s).

Pour mieux préciser le cadre de l'invention, on décrit ci-dessous rapidement les signaux que l'on trouve aux bornes des différents modules du système de la figure 1. On utilise pour cela une représentation fréquentielle, les signaux étant décrits par leur spectre, en faisant abstraction de leur phase.

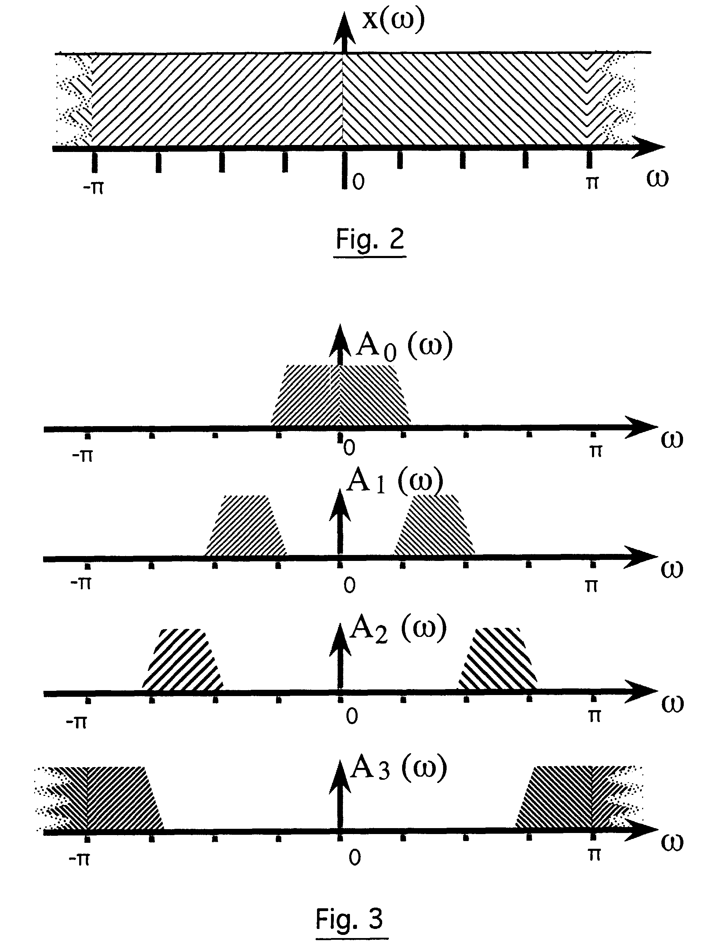

Le spectre X(ω) du signal d'entrée x(s) numérisé est donc présenté en figure 2. On notera que ce signal étant numérisé, le spectre est périodique de période 2π, ainsi que cela est symbolisé par les hachures inclinées à droite et à gauche respectivement. Il convient de garder à l'esprit, par la suite, que tous les signaux décrits sont périodiques de période 2π.

Le signal x(s) est donc filtré par le banc de filtres 11. Pour simplifier la description, on considère ici le cas d'une transformation en sous-bandes délivrant seulement quatre sous-bandes de largeurs identiques. La généralisation est toutefois aisée.

La figure 3 illustre les quatre signaux A₀(ω) à A₃(ω) obtenus en sortie du banc de filtres 11.

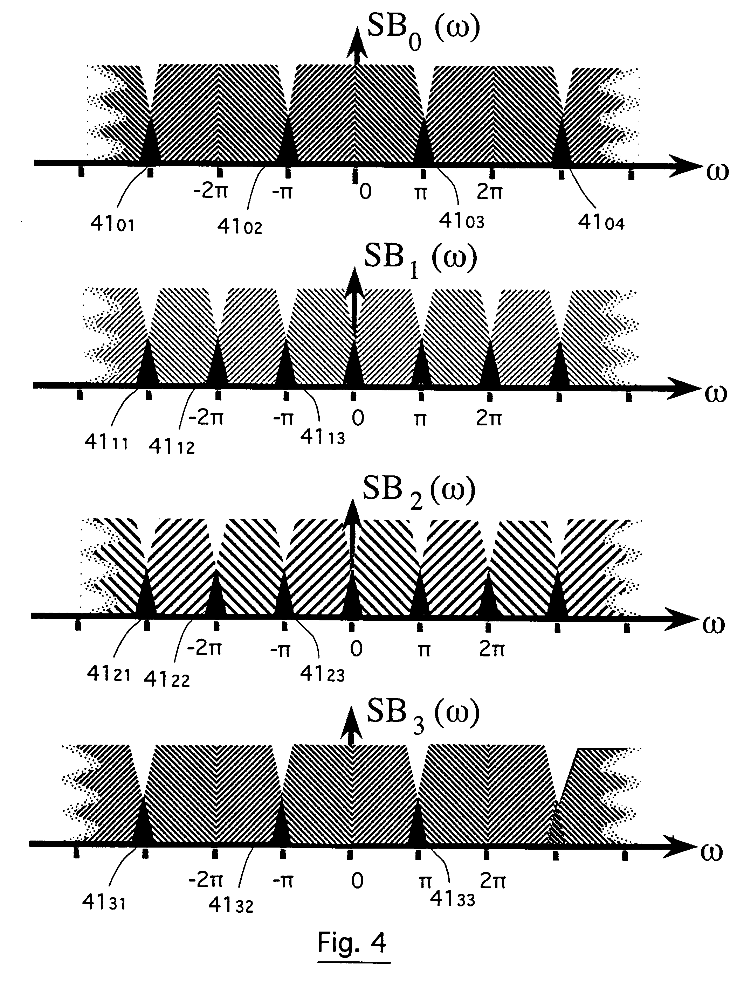

Ces signaux sont ensuite sous-échantillonnés par des modules 12₀ à 12₃. Le sous-échantillonnage entraîne classiquement une répétition du spectre d'origine dans le domaine fréquentiel, pouvant entrainer des repliements de spectre. Le spectre des quatre sous-bandes SB₀(ω) à SB₃(ω) délivrés par les sous-échantillonneurs est représenté en figure 4.

On constate que la recopie des spectres de base entraîne le phénomène de repliements de spectres (les spectres se chevauchent). Sur cette figure 4, les termes principaux des repliements 41₀ⱼ à 41₃ⱼ sont seuls représentés. Toutefois, dans la réalité, il apparaît également des termes secondaires (d'importance d'autant plus faible que les filtres d'analyse sont efficaces) qui ne sont pas représentés par souci de simplification. Ces repliements de spectres secondaires (ainsi que les repliements principaux) sont d'autant plus faibles que les filtres employés sont sélectifs comme dans les bancs PQMF par exemple.

Les quatre sous-bandes SB₀ à SB₃ ainsi obtenues, qui sont les signaux de sortie de la transformation directe, seront diversement modifiées et traitées suivant l'application utilisant cette transformation.

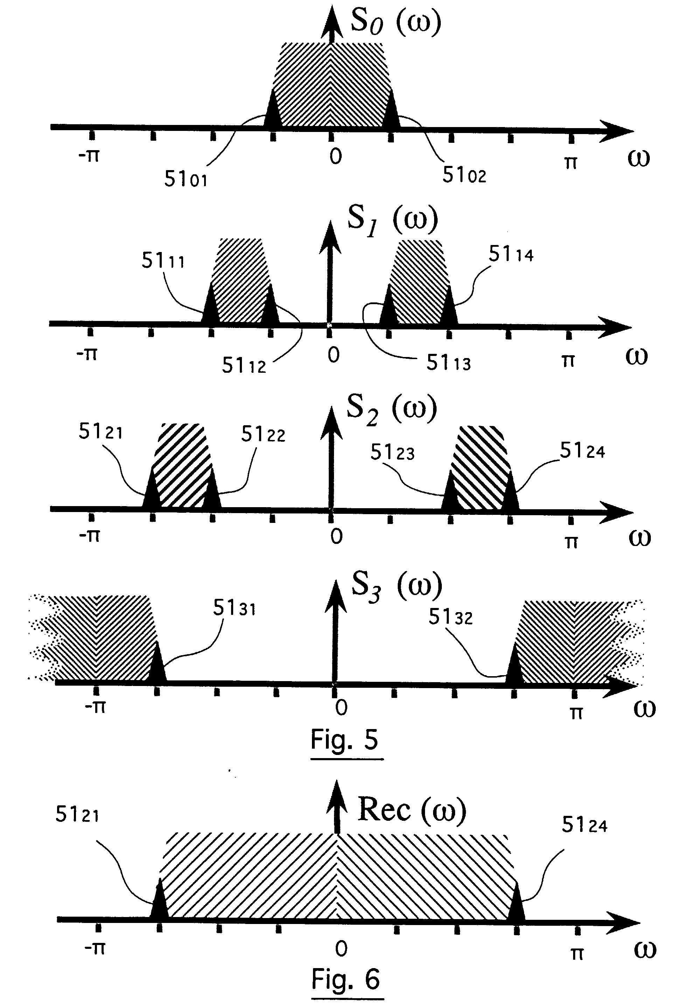

Dans le cas où aucun traitement n'est effectué, la transformation inverse permet d'obtenir un signal reconstruit rec(s) identique, ou quasi identique, à un délai près, au signal d'entrée x(s), malgré la présence des différents repliements de spectre 41ᵢⱼdes spectres S₀(ω) à S₃(ω) tels que représentés en figure 5. Ces spectres présentent effectivement des repliements 51ᵢⱼ. Toutefois, ceux-ci vont se compenser deux à deux lors de la sommation 16, car ils sont de même amplitude et de phases opposées.

Plus précisément les compensations sont les suivantes :
- repliements 51₀₁ et 51₀₂ avec repliements 51₁₂ et 51₁₃ respectivement;
- repliements 51₁₁ et 51₁₄ avec repliements 51₂₂ et 51₂₃ respectivement;
- repliements 51₂₁ et 51₂₄ avec repliements 51₃₁ et 51₃₂ respectivement.

On obtient donc finalement un signal reconstitué correspondant bien au signal d'origine tel que représenté en figure 2.

En revanche, selon les techniques de filtrage en sous-bandes connues, dès que l'une des sous-bandes SB₀ à SB₃ subit un traitement particulier, ces compensations ne s'effectuent plus, ou tout au moins pas de façon complète. Le signal reconstitué est donc plus ou moins pollué.

On notera la différence entre les filtrages d'analyse ou de synthèse, qui ont pour objectif la réalisation d'une transformation (changement d'espace), et le traitement de filtrage des sous-bandes, dont le but est de modifier le signal, par exemple de la quantité d'information nécessaire en vue d'une réduction de débit.

Ainsi, si l'on souhaite réaliser un filtre trois-quart de bande, éliminant le quart des plus hautes fréquences, il suffit en principe d'annuler, en la multipliant par zéro la sous-bande SB₃(ω). Le filtrage s'avère donc particulièrement simple. Par ailleurs, il s'effectue à une fréquence quatre fois plus faible que la fréquence d'échantillonnage du signal source.

Toutefois, il est clair que les repliements de spectres 51₂₁ et 51₂₄ de la sous-bande S₂(ω) ne sont plus compensés, puisque les repliements 51₃₁ et 51₃₂ ont été supprimés. Ils apparaissent donc dans le spectre du signal reconstitué, illustré en figure 6.

En outre si les filtres en sous-bandes utilisés sont très sélectifs en fréquence, et dans le cas d'une annulation pure et simple de certaines sous-bandes, le signal reconstruit risque de présenter des "rebonds" autour des contours, lorsque le filtrage est appliqué au traitement d'images.

Pour obtenir un filtre moins sélectif dans le domaine fréquentiel, et donc des rebonds moindres autour des contours, il est possible par exemple d'annuler SB₃ et de multiplier SB₂ par 1/2. Ce traitement est illustré par la figure 7 (après filtrage de synthèse). Le spectre reconstitué après addition des sous-bandes filtrées de la figure 7, est présenté en figure 8. Le filtre global obtenu est effectivement moins sélectif. En revanche, les problèmes de perturbations introduites par les repliements de spectres subsistent, et même se multiplient. En effet, ces repliements n'ayant plus la même amplitude avant l'addition finale des bandes, ils ne peuvent plus se compenser.

Ainsi, sur la figure 7, les repliements 71₂₁ et 71₂₄ de la sous-bande S₂ n'ont pas de correspondants dans la sous-bande S₃, et se retrouvent (81 et 84, figure 8) sur le spectre final, et les repliements 71₂₂ et 71₂₃ ne se compensent que partiellement avec les repliements 71₁₁ et 71₁₄ de la sous-bande S₁, qui n'a subi aucun traitement. Le spectre reconstruit comprend également deux résidus 82 et 83.

Il est clair que si l'on avait filtré le signal source x(s) directement avec un filtre ayant le profil représenté en figure 8, les différents termes 81 à 84 n'existeraient pas.

L'invention propose un nouveau procédé de filtrage en sous-bandes, permettant d'obtenir un profil de filtrage global non, ou peu, perturbé par les repliements de spectres. De plus, le procédé de filtrage selon l'invention permet de produire de très nombreux profils de filtrage, beaucoup plus variés que ceux classiquement obtenus selon les méthodes antérieures à multiplication par un coefficient pondérateur de certaines sous-bandes.

L'invention repose sur une approche tout à fait nouvelle du filtrage en sous-bandes. En effet, selon l'art antérieur, on considère que les N signaux de sous-bandes issus du banc de filtres d'analyse sont indépendants. Le traitement de chacun d'entre eux correspond donc en fait à N traitements particuliers réalisés en parallèle indépendamment les uns des autres.

L'approche nouvelle du filtrage des sous-bandes selon l'invention est opposée. En effet, le traitement appliqué à une sous-bande donnée influe systématiquement sur le traitement appliqué à au moins certaines des autres sous-bandes, et notamment aux bandes fréquentiellement voisines. En d'autres termes, le filtrage appliqué à chaque sous-bande est contraint par le filtrage réalisé dans les sous-bandes voisines, de façon que les repliements de spectres s'annulent lors de la reconstruction.

Les sous-bandes ne sont donc plus simplement multipliées par un coefficient atténuateur, mais subissent un filtrage adapté particulier. On notera que, de cette manière, de nombreux types de filtres peuvent être générés.

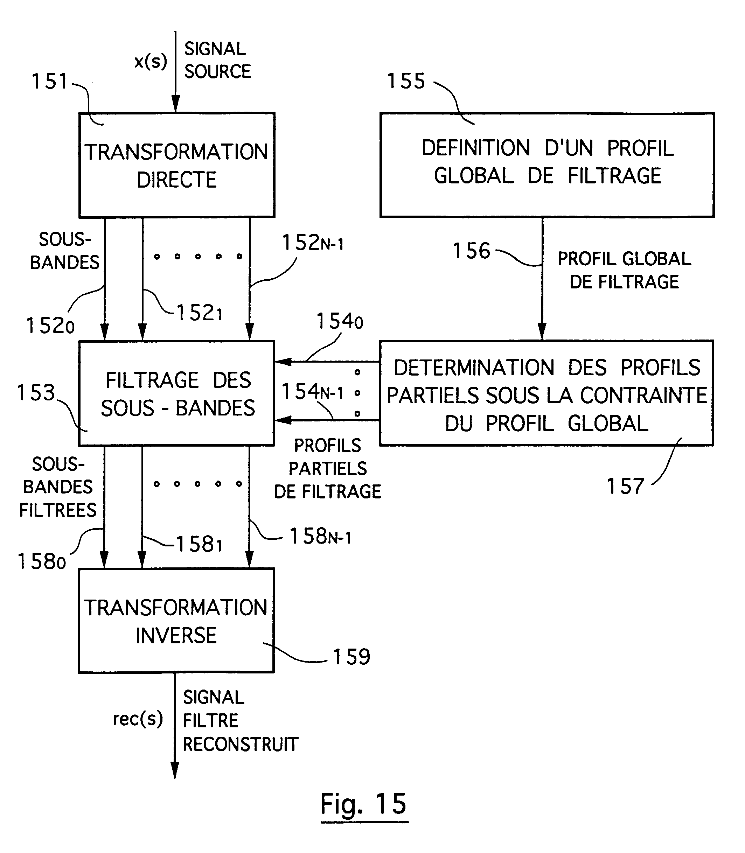

La figure 15 présente de façon synoptique le procédé de filtrage selon l'invention. Le signal source x(s) est tout d'abord transformé (151) en plusieurs sous-bandes de fréquence 152₀ à 152_{N-1}, selon toute technique de transformation connue (filtrage en sous-bandes, transformation mathématique,...). Chacune de ces sous-bandes 152₀ à 152_{N-1} est ensuite filtrée (153), selon un profil partiel de filtrage 154₀ à 154_{N-1} associé à chaque sous-bande.

Pour déterminer ces profils partiels de filtrage, on a premièrement défini (155) un profil global de filtrage 156, destiné à filtrer le signal source x(s). En effet, selon l'invention, l'objectif est d'obtenir un filtrage prédéfini du signal source, et non pas un filtrage indépendant de chaque sous-bande 152₀ à 152_{N-1}.

A partir de ce profil global de filtrage 156, on détermine (157) autant de profils partiels de filtrage 154₀ à 154_{N-1}, destinés à filtrer chacun une des sous-bandes. La caractéristique essentielle de cette étape 157 de détermination des profils partiels de filtrage est qu'elle est effectuée sous la contrainte du profil global de filtrage voulu 156. Cela implique que, contrairement à l'art antérieur qui se limitait à appliquer des coefficients de pondération à chaque sous-bande, des profils spécifiques de filtrage 154₀ à 154_{N-1} sont calculés de façon que, lorsque les différentes sous-bandes filtrées 158₀ à 158_{N-1} subissent une transformation 159 inverse de la transformation 151, le signal filtré reconstruit rec(s) soit identique, ou à tout le moins très proche, du signal correspondant au filtrage direct du signal source x(s) selon le profil global de filtrage 156.

Notamment, l'étape de détermination 157 doit donc contraindre chaque profil partiel de façon que les repliements de spectre apparaissant lors de l'opération 153 de filtrage des sous-bandes soient compensés lors de la reconstruction par transformation inverse 159. Ainsi, une caractéristique essentielle de l'invention est que la détermination d'un profil partiel de filtrage impose la prise en compte de ses profils de filtrage voisins selon l'axe fréquentiel.

Il est à noter que, selon l'invention, on ne vise pas systématiquement à supprimer ou à atténuer les repliements de spectre présents dans chaque sous-bande filtrée. En effet, l'objectif n'est pas de limiter les repliements dans chaque sous-bande filtrée, mais de faire en sorte que les repliements de spectre apparus dans les différentes sous-bandes filtrées se compensent lors de la reconstruction du signal. En conséquence, l'opération de détermination des profils partiels de filtrage peut, dans certains cas, provoquer ou amplifier volontairement des repliements de spectre, qui en compenseront d'autres.

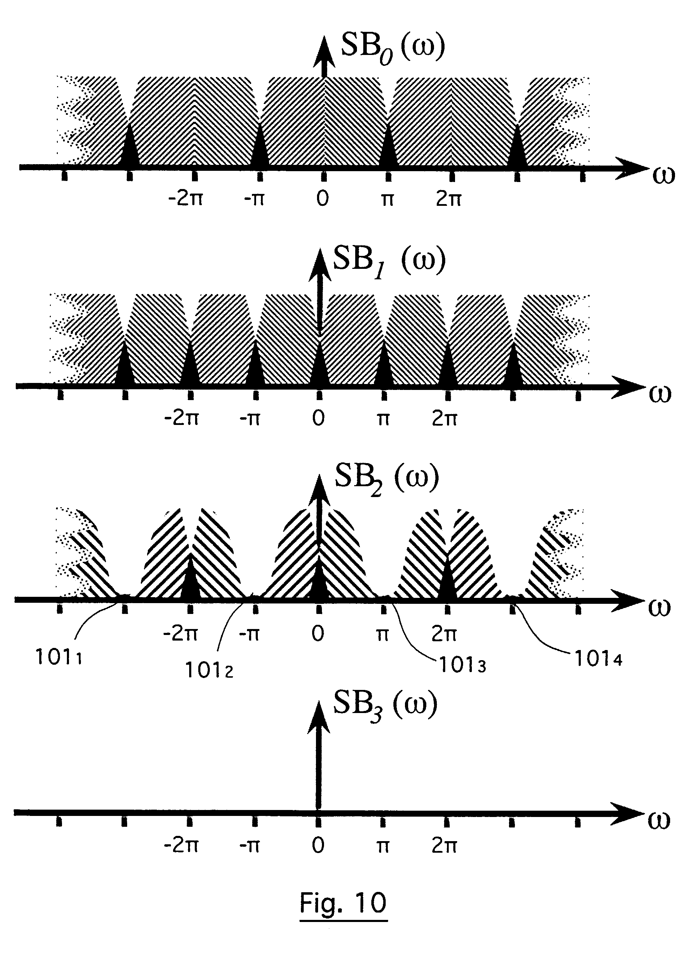

La figure 9 illustre le principe général d'un dispositif mettant en oeuvre l'invention, dans le cas simplifié déjà considéré de quatre sous-bandes.

Le signal source x(s) est tout d'abord transformé, à l'aide d'un banc de filtres d'analyse 91 (ou tout autre moyen de transformation). Ce banc de filtres délivre quatre sous-bandes SB₀ à SB₃, qui sont dirigés vers un module 92 de filtrage, comprenant quatre filtres indépendants 92₀ à 92₃ (F0 à F3).

Les signaux filtrés 94₀ à 94₃ subissent ensuite une transformation inverse 93, par exemple à l'aide d'un banc de filtres de synthèse, qui délivre le signal reconstitué rec(s).

Il est à noter que ces signaux filtrés 94₀ à 94₃ ne sont généralement pas retransformés dans le domaine temporel aussitôt après filtrage, mais subissent au contraire d'autres traitements, par exemple en vu d'obtenir une réduction de débit, dans une chaîne codeur/décodeur d'images ou de sons. En d'autres termes, le banc de filtres d'analyse 91 et le module de filtrage 92 correspondent à la partie émission ou codage de la chaîne, et le banc de filtres de synthèse 93 correspondant à la partie réception ou décodage.

Le dispositif de l'invention comprend également un module 95 de calcul des coefficients de filtrage. De façon schématique, on peut considérer que ce module 95 comporte quatre (plus généralement autant que de sous-bandes) sous-modules 95₀ à 95₃, délivrant les coefficients 96₀ à 96₃ de chaque filtre 92₀ à 92₃.

Selon l'invention, le calcul des coefficients tient compte des sous-bandes voisines. Ainsi, chaque module de calcul 95₁ prend en compte dans son calcul d'informations 97₀ et 97₂ représentatives du profil calculé pour les sous-modules 95₀ et 95₂, (par exemple les valeurs des coefficients déterminés par ces modules).

Dans la réalité, le calcul des coefficients peut bien sûr se faire de façon différente, à l'aide d'un module de calcul unique, par exemple, ainsi qu'on le verra par la suite, en appliquant la règle des "tangentes horizontales".

Dans un mode de réalisation simple, les valeurs des coefficients peuvent être figées. Le module 95 est alors par exemple une simple mémoire contenant des valeurs précalculées.

Toutefois, avantageusement, ces valeurs sont variables, en fonction d'un ou plusieurs critères 98 délivré par un module 99 déterminant une contrainte de filtrage. On peut ainsi par exemple tenir compte d'un débit fixé, de critères psychoacoustiques ou psychovisuels (par exemple quantité de mouvement dans une image, ...), etc ...

Dans une version simple, le module 95 est une mémoire contenant plusieurs valeurs de filtrage, et le module 99 de contrainte sélectionne l'une des valeurs. Dans un mode de réalisation plus complexe, le module de calcul 95 peut avantageusement être un calculateur, déterminant en temps réel les coefficients de filtrage optimaux.

Deux exemples de filtrages obtenus selon le procédé de l'invention vont maintenant être décrits. Ils fournissent des profils de filtrage proches de ceux correspondants aux deux exemples de filtrage selon l'art antérieur, avec toutefois deux différences essentielles :
- il n'y a plus de perturbations dues aux repliements de spectres dans le signal reconstruit ;
- le profil de filtrage global présente des transitions fréquentielles beaucoup plus "douces".

Dans le premier exemple, illustré par les figures 10 à 13, on cherche à réaliser un filtre passe-bas trois-quart de bande.

Ainsi que cela est illustré en figure 10, la sous-bande SB₃, correspondant aux hautes fréquences, est mise à zéro, de même que dans le cas connu discuté précédemment.

En revanche, la sous-bande voisine SB₂ subit un filtrage particulier, qui permet de fortement atténuer les repliements de spectres 101₁ à 101₄, qui n'ont plus de correspondant dans la sous-bande SB₃.

La caractéristique essentielle de l'invention est de réaliser, sur au moins une des sous-bandes (ici : SB₂) un filtrage adapté, et non plus une simple multiplication.

Le filtre utilisé ici est un filtre passe-bas, par exemple de coefficients [1/4, 1/2, 1/4].

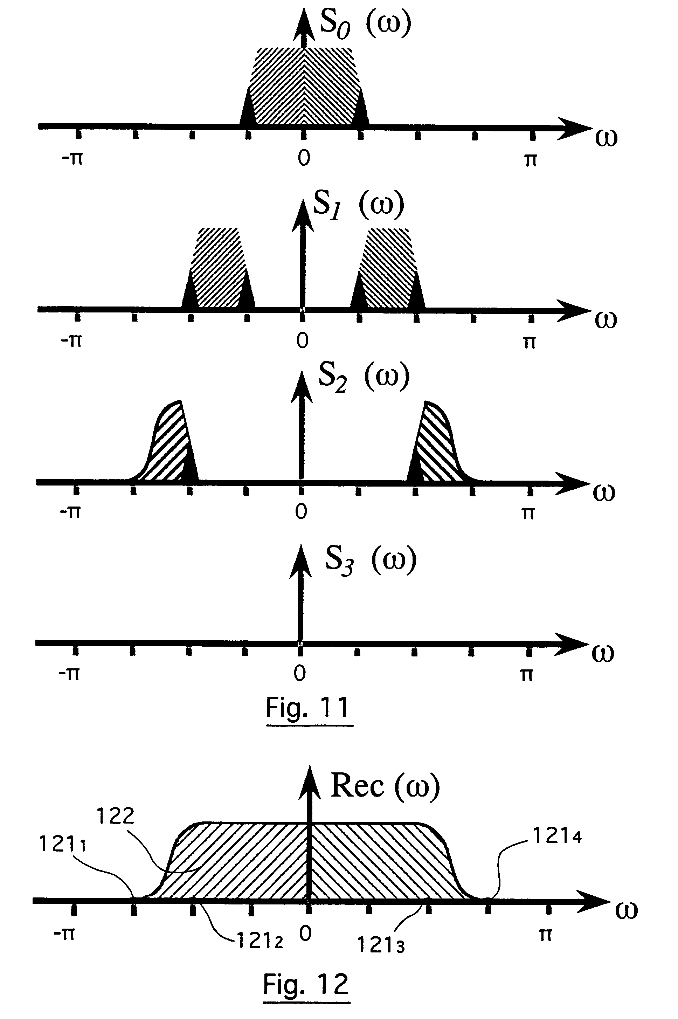

La figure 11 présente les signaux S₀ à S₃ obtenus après filtrage de synthèse. On constate que les repliements de spectres conservés s'annulent bien deux à deux, et qu'il ne reste pas, ou très peu, de termes "polluants". En effet, le filtre passe-bas de la sous-bande SB₂ a supprimé en grande partie la zone fréquentielle où résidait les repliements des spectres non compensés.

Le spectre du signal reconstruit, représenté en figure 12 ne comporte donc plus de repliements. Dans la pratique, de très faibles perturbations 121₁ à 121₄ peuvent subsister. Toutefois, elles sont sans commune mesure avec celles apparaissant dans le cas des filtrages connus, tel qu'illustré en figure 6.

Par ailleurs, on constate, toujours par rapport à la figure 6, que la transition fréquentielle est adoucie (122), ce qui est avantageux, notamment dans le cas où les filtres de transformation en sous-bandes sont très sélectifs.

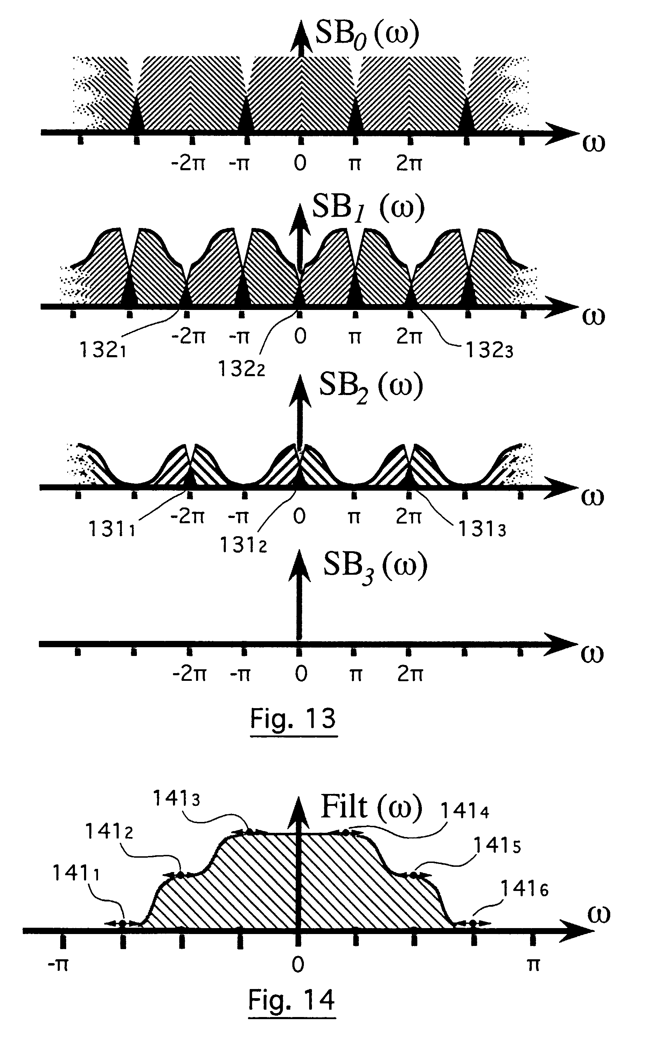

Selon l'invention, le profil de filtrage de chaque sous-bande est contraint en fonction des sous-bandes voisines. Cela apparaît encore plus clairement dans le second exemple, illustré par les figures 13 et 14.

Pour obtenir un profil de filtrage plus mou, il est possible de filtrer plusieurs sous-bandes de façon adaptée, ainsi que cela est représenté en figure 13.

Il s'agit toujours d'obtenir un filtre trois-quart de bande. La sous-bande SB₃ est donc toujours annulée. La sous-bande SB₂ subit à nouveau un filtrage passe-bas, mais est de plus atténuée, par exemple à l'aide du filtre de coefficients [1/8, 1/4, 1/8].

Cette atténuation se traduit naturellement par une modification des termes 131₁ à 131₃ de repliements de spectres. Pour obtenir une compensation parfaite de ces termes, il est donc nécessaire de contraindre le profil de filtrage de la sous-bande SB₁.

La sous-bande SB₁ doit en effet être filtrée passe-haut, à l'aide d'un filtre tel que le filtre de coefficient [- 1/8, 3/4, - 1/8], pour que les repliements 132₁ à 132₃ se compense bien avec les repliements 131₁ à 131₃ de la sous-bande SB₂.

Le spectre du signal reconstruit, après filtrage de synthèse et addition est présenté en figure 14.

On constate qu'on obtient un profil de filtre passe-bas peu sélectif, et non (ou très peu) perturbé par les repliements de spectre.

Il apparaît clairement ici que le filtrage de chaque sous-bande n'est pas fait indépendamment, mais qu'au contraire, il est contraint par celui appliqué aux sous-bandes voisines. On peut notamment remarquer que, pour obtenir un profil global de type passe-bas, tel qu'illustré en figure 14, on applique sur la sous-bande SB₁ un filtrage passe-haut. Ceci tient au fait de l'inversion de spectre subi par certaines bandes du fait du sous-échantillonnage (ainsi que l'illustre le sens des hachures dans les diverses figures).

On notera toutefois que certaines transformations corrigent cet effet en changeant le signe d'un point sur deux dans les sous-bandes inversées spectralement, ceci ayant pour effet de "redresser le spectre". Il convient donc de vérifier ce point avant toute mise en oeuvre.

Une solution avantageuse pour mettre en oeuvre le procédé de l'invention est de faire en sorte que le profil de filtrage global présente des tangentes horizontales dans les zones fréquentielles 141₁ à 141₆ (fig. 14) transitoires entre les divers filtres de la transformation.

Ceci fait, il est aisé de trouver les filtres à appliquer aux diverses sous-bandes pour obtenir l'allure générale souhaitée. Si la condition de tangentes horizontales est respectée, ces filtres à appliquer aux sous-bandes ont de fait une tangente horizontale aux diverses positions fréquentielles 0 modulo π. Les différents repliements de spectres se compensent alors sans problème.

Pour obtenir de bons résultats, il est préférable que les filtres utilisés dans la transformation en sous-bandes soient très sélectifs, pour n'avoir dans les sous-bandes que des repliements de spectres principaux. En effet, les repliements secondaires de spectres ne se compensent pas, dans le mode de réalisation préférentiel décrit.

L'invention peut être mise en oeuvre de façon aisée, du point de vue matériel.

En effet, les sous-bandes étant des signaux sous-échantillonnés, la fréquence d'horloge des traitements à leur appliquer est réduite par rapport à la fréquence du signal d'entrée. En outre, de nombreuses transformations en sous-bandes les plus connues (DCT, FFT, PQMF, QMF, ...) peuvent être obtenues par l'entremise d'algorithmes rapides.

Par ailleurs, il est tout à fait possible, et même avantageux de choisir des filtres très simples pour filtrer les sous-bandes.

Ainsi, les filtres obtenus par combinaison linéaires du filtre passe-bas [1/4, 1/2, 1/4] et du filtre identité [0, 1, 0] donnent de très bons résultats. Ces filtres ont pour expression [0.25*α, 0.5*α+ß, 0.25*α]. La contrainte de tangente horizontale donne les relations que doivent vérifier entre eux les divers coefficients réels α et β.

Dans le cas bidimensionnel, de même, les combinaisons linéaires des quatre filtres identité (ID), passe-bas en X (PB_X), passe-bas en Y (PB_Y) et passe-haut en XY (PH_XY) illustrés par la table I suivante donnent d'excellents résultats.

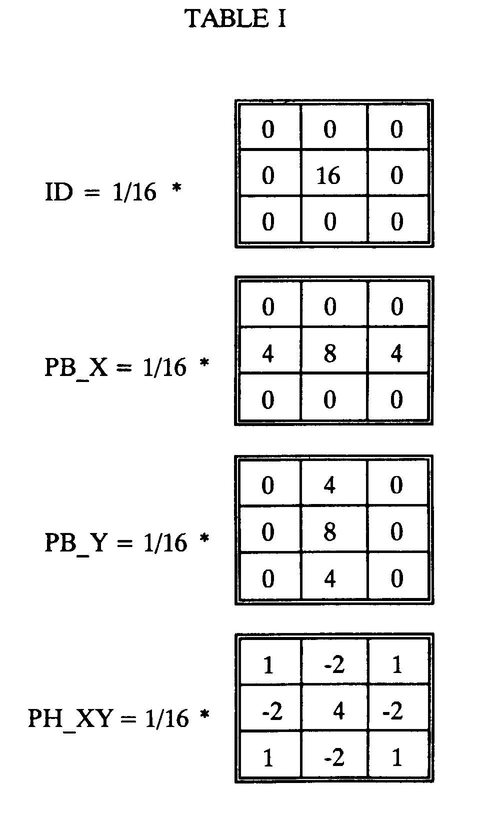

Le même principe peut bien sûr être généralisé pour les cas multidimensionnels.

L'avantage des filtres décrits ci-dessus est qu'ils sont de taille très faible et travaillent sur des signaux sous-échantillonnés, et qu'ils sont très facilement implantables en hardware. En outre, si les coefficients des diverses combinaisons linéaires sont bien choisis, les filtres peuvent s'implanter en n'utilisant que des additions et des décalages de bits, donc sans multiplication.

Il est clair également que des filtres plus complexes peuvent aussi être utilisés.

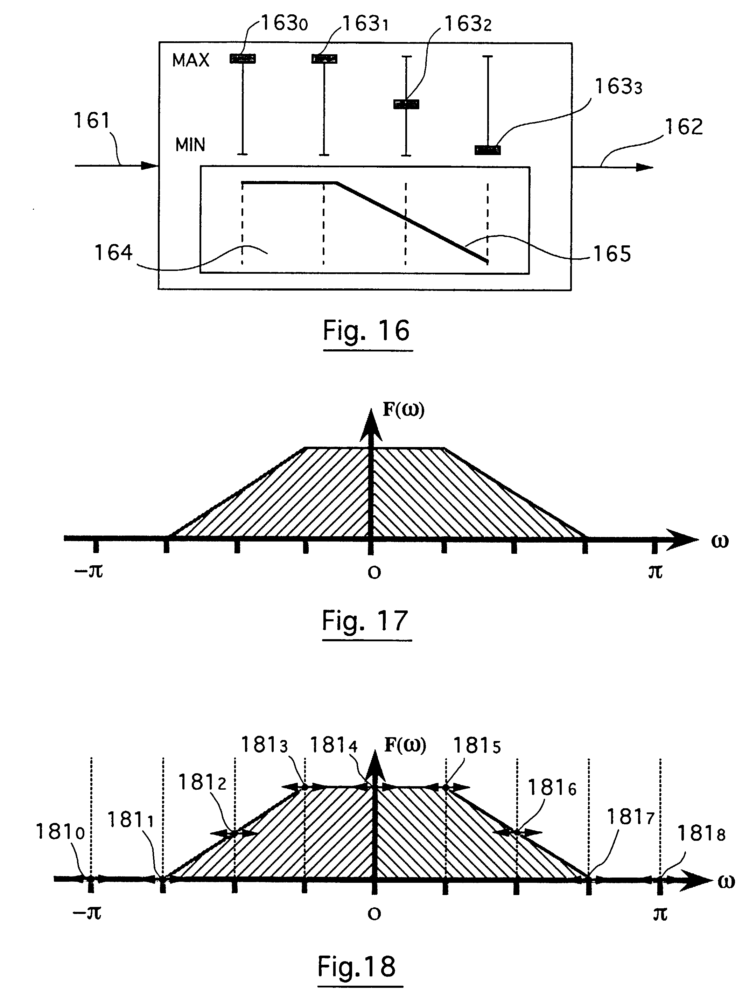

On présente maintenant, en relation avec les figures 16 à 20, un mode de réalisation détaillé du procédé déjà décrit en liaison avec la figure 9 mettant en oeuvre le critère des tangentes horizontales.

On considère, à titre d'exemple d'utilisation, donné bien sûr à titre de simple illustration, le cas d'un égaliseur pour signaux de son, tel que schématiquement représenté en figure 16.

Cet égaliseur reçoit en entrée un signal source 161, et délivre en sortie un signal égalisé 162. Il dispose d'un jeu de potentiomètres 163₀ à 163₃, correspondant chacun à une bande de fréquences. Chacun de ces potentiomètres 163₀ à 163₃ peut être déplacé entre deux bornes "Max" et "Min" correspondant respectivement à la conservation et à la suppression de la sous-bande correspondante.

Un afficheur 164, par exemple à cristaux liquides, permet de visualiser le profil de filtrage déterminé à l'aide des potentiomètres.

Bien qu'on se soit limité, dans cet exemple, à un égaliseur à quatre potentiomètres (par souci d'homogénéité avec les exemples déjà décrits), il est clair qu'un tel égaliseur comporterait sans doute, dans la pratique, un nombre plus élevé de potentiomètres (par exemple 8 à 15, voire plus), permettant un réglage fin de l'égalisation. Par ailleurs, dans le cas classique d'un égaliseur stéréophonique, l'ensemble décrit ci-dessus serait bien sûr dédoublé, de façon à traiter en parallèle les deux signaux stéréophoniques.

Dans l'exemple de la figure 16, on a défini à l'aide des potentiomètres 163₀ à 163₃ un filtrage passe-bas, tel que présenté (165) par l'afficheur 164.

Le traitement effectué par l'égaliseur est alors le suivant.

Tout d'abord, on détermine le profil global de filtrage F(ω) correspondant au réglage des potentiomètres, tel qu'illustré en figure 17 (étape 155 ; fig.15). Il s'agit d'un profil de référence, ou profil souhaité.

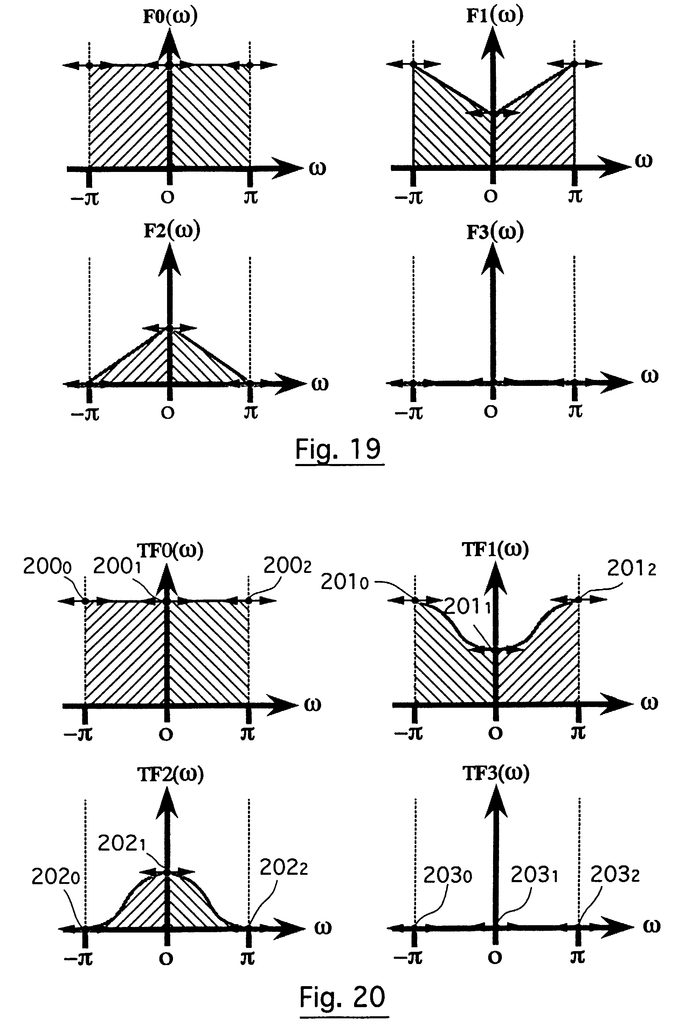

A partir de ce profil de référence F(ω), on détermine ensuite les profils partiels destinés au filtrage de chaque sous-bande (étape 157; ; fig.15). cette étape peut être découpée en trois sous-étapes :
- on repère (figure 18) sur le profil de référence F(ω) les points 181₀ à 181₈ où la contrainte de tangente horizontale devra être vérifiée. Ces points correspondent bien sûr aux limites de chaque sous-bande, c'est-à-dire les points où apparaissent les repliements de spectre principaux ;
- on détermine (figure 19) le profil partiel souhaité (F0(ω) à F3(ω)) pour chaque sous-bande correspondant au profil global de la figure 17. Ainsi qu'on l'a déjà signalé, on notera que les sous-bandes de numéro impair (F1(ω), F3(ω)) subissent une inversion fréquentielle (due au sous-échantillonnage) ;
- on recherche (figure 20) les profils partiels (TF0(ω) à TF3(ω)) les plus proches possibles des profils idéaux (F0(ω) à F3(ω)), parmi les filtres disponibles. Plus précisément, chacun de ces profils partiels est choisi de façon que :
   - le filtre approxime le profil voulu ;
   - le profil présente une tangente horizontale aux points 0 et π modulo 2π (200₀ à 200₂ ; 201₀ à 201₂ ; 202₀ à 202₂ ; 203₀ à 203₂).

Dans le cas déjà mentionné d'une telle approximation à l'aide de filtres à trois coefficients de la forme [0,25 * α ; 0,5 * α + β ; 0,25 * α], cette recherche des profils partiels consiste donc à déterminer les valeurs α et β remplissant les deux critères ci-dessus.

Dans cet exemple, cette opération est particulièrement simple. En effet, les valeurs aux points 0 et π spécifient directement les valeurs α et β. Plus précisément, la valeur au point 0 donne la somme α + β, et la valeur au point π donne β.

Dans le cas où l'on ne dispose que d'un jeu fini de filtres, on choisit bien sûr celui présentant les valeurs α et β les plus proches.

Ainsi, dans l'exemple de la figure 20, on peut vérifier que l'on retrouve bien les filtres déjà décrits en liaison avec la figure 13 (il s'agit en effet du même filtrage passe-bas), ainsi que le montre le tableau suivant :

| sous-bande | α + β | β | α | filtre |
|---|---|---|---|---|
| TF0(ω) | 1 | 1 | 0 | [0 ; 1 ; 0] |
| TF1(ω) | 1/2 | 1 | -1/2 | [-1/8 ; 3/4 ; -1/8] |
| TF2(ω) | 1/2 | 0 | 1/2 | [1/8 ; 1/4 ; 1/8] |
| TF3(ω) | 0 | 0 | 0 | [0 ; 0 ; 0] |

Ces différents filtres partiels sont ensuite appliqués aux sous-bandes correspondantes, ainsi que cela est illustré en figure 13. Le signal reconstruit présente alors le spectre représenté en figure 14.

Le profil global de filtrage de la figure 14 est donc le profil effectivement réalisé, correspondant sensiblement au profil de référence de la figure 16. Bien sûr, conformément à l'objectif de l'invention, il ne présente pas de repliements de spectre.

## Revendications

1. Procédé de filtrage d'un signal numérique source (x(s)) décomposé en sous-bandes comprenant une phase de définition du filtrage et une phase de filtrage, ladite phase de définition comprenant les étapes de :
- définition (155) d'un profil global de filtrage (156 ; figures 12 à 14) correspondant à un filtrage destiné à être appliqué audit signal numérique source (x(s)) ;
- détermination (157) d'un jeu de profils partiels de filtrage (154₀ à 154_{N-1} ; figures 11 et 13) caractérisé par au moins deux coefficients de filtrage et associés chacun à une desdites sous-bandes (152₀ à 152_{N-1}), lesdits profils partiels de filtrage (154₀ à 154_{N-1}) étant déterminés à partir dudit profil global de filtrage (156) de façon que, lors d'une transformation inverse, au moins certains d'entre eux génèrent des termes de repliement de spectres (132₁ à 132₃) destinés à se compenser avec d'autres termes de repliement de spectres générés par d'autres profils de filtrage partiel ;
et ladite phase de filtrage comprenant les étapes de :
- transformation (151) du domaine temporel dans le domaine fréquentiel dudit signal numérique source (x(s)), délivrant au moins deux sous-bandes de fréquence distinctes (152₀ à 152_{N-1} ; SB₀ à SB₃) ;
- filtrage (153) de chacune desdites sous-bandes (152₀ à 152_{N-1}) selon le profil partiel de filtrage (154₀ à 154_{N-1}) qui lui est associé, ladite étape de filtrage (153) associant à chacune desdites sous-bandes (152₀ à 152_{N-1}) une sous-bande filtrée correspondante (158₀ à 158_{N-1}), ladite sous-bande filtrée présentant des repliements de spectre (131₁ à 131₃, 132₁ à 132₃) dus au filtrage (153) selon ledit profil partiel de filtrage ; et
- transformation (159) inverse de ladite étape de transformation (151), du domaine fréquentiel dans le domaine temporel, desdites sous-bandes filtrées (158₀ à 158_{N-1}), délivrant un signal filtré reconstruit (rec(s)).

2. Procédé selon la revendication 1 caractérisé en ce que ladite étape de détermination (157) d'un jeu de profils partiels de filtrage comprend, pour au moins un desdits profils partiels de filtrage (154₀ à 154_{N-1}), une étape de contrainte (157) dudit profil partiel de filtrage en fonction d'au moins un de ses profils partiels de filtrage voisins dans le domaine des fréquences, contraignant ledit profil partiel de filtrage de façon que, lors de ladite étape de transformation inverse (159), les repliements de spectres (132₁ à 132₃) restant après le filtrage selon ledit profil de filtrage lors de ladite étape de filtrage (153) se compensent sensiblement avec les repliements de spectre (131₁ à 131₃) restant après le filtrage selon ledit au moins un profil partiel de filtrage voisin.

3. Procédé selon la revendication 2 caractérisé en ce que ladite étape de contrainte (157) contraint lesdits profils partiels de filtrage (154₀ à 154_{N-1}) de façon que le spectre (figures 12 et 14) dudit signal reconstruit (rec(s)) soit continu.

4. Procédé selon l'une quelconque des revendications 2 et 3, caractérisé en ce que ladite étape de contrainte (157) contraint au moins un desdits profils partiels de filtrage (154₀ à 154_{N-1}) de façon qu'il présente des tangentes (141₁ à 141₃) sensiblement horizontales au voisinage des positions fréquentielles égales à 0 modulo π.

5. Procédé selon l'une quelconque des revendications 1 à 4 caractérisé en ce que lesdits profils partiels de filtrage (154₀ à 154_{N-1}) sont obtenus par combinaison linéaire d'au moins un filtre de base appartenant à un jeu d'au moins un filtre de base prédéfinis.

6. Procédé selon la revendication 5, caractérisé en ce que ladite combinaison linéaire met en oeuvre des coefficients multiplicateurs fixés de façon que les filtres obtenus soient implantables sans multiplication, à l'aide d'un jeu d'additions et de décalages binaires.

7. Procédé selon l'une quelconque des revendications 5 et 6, caractérisé en ce que ledit signal source est un signal monodimensionnel, et en ce qu'au moins un desdits profils partiels de filtrage est obtenu à l'aide d'un filtre de base de coefficients :
[0,25 * α ; 0,5 * α + β; 0,25 * α], or et β étant des nombres réels.

8. Procédé selon l'une quelconque des revendications 5 et 6, caractérisé en ce que ledit signal source est un signal bidimensionnel, et en ce qu'au moins un desdits profils partiels de filtrage est obtenu par combinaison linéaire d'au moins un des filtres de base de coefficients suivants :

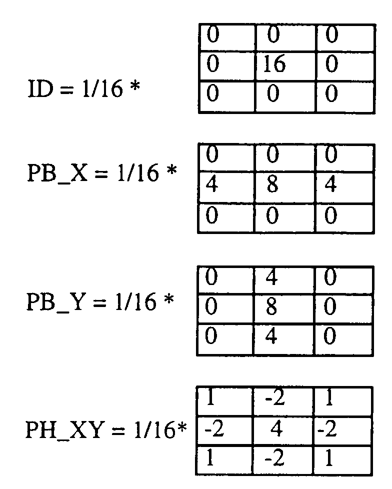

9. Procédé selon l'une quelconque des revendications 1 à 8, caractérisé en ce que ladite étape de transformation (151) comprend une étape (151) d'application d'un banc de filtres d'analyse (11) et en ce que ladite étape de transformation inverse (159) comprend une étape (159) d'application d'un banc de filtres de synthèse (15), lesdits filtres d'analyse et de synthèse étant des filtres très sélectifs en fréquence.

10. Dispositif de filtrage d'un signal numérique source (x(s)) caractérisé en ce qu'il comprend :
- des moyens de transformation (91) du domaine temporel dans le domaine fréquentiel dudit signal numérique source (x(s)), délivrant au moins deux sous-bandes de fréquence distinctes (SB₀ à SB₃);
- des moyens (95) de détermination d'un jeu de profils partiels de filtrage (96₀ à 96₃) associés chacun à une desdites sous-bandes (SB₀ à SB₃), lesdits profils de filtrage étant déterminés à partir d'un profil global de filtrage (98) correspondant à un filtrage destiné à être appliqué audit signal numérique source (x(s)) et étant contraint de façon que le signal filtré reconstruit (rec(s)) corresponde sensiblement au filtrage direct dudit signal numérique source (x(s)) selon ledit profil global de filtrage (98), au moins certains desdits profils partiels induisant, lors de la reconstruction, des termes de repliement de spectre tels qu'ils se compensent avec les termes de repliements de spectre induits par les autres profils partiels ;
- des moyens de filtrage (92₀ à 92₃) de chacune desdites sous-bandes (SB₀ à SB₃) selon le profil partiel de filtrage (96₀ à 96₃) qui lui est associé, associant à chacune desdites sous-bandes (SB₀ à SB₃) une sous-bande filtrée correspondante (94₀ à 94₃) ; et
- des moyens de transformation (93) inverse de ladite étape de transformation (91) du domaine fréquentiel dans le domaine temporel desdites sous-bandes filtrées (94₀ à 94₃), délivrant un signal filtré reconstruit (rec(s)).

11. Application du procédé de filtrage selon l'une quelconque des revendications 1 à 9 à l'un des traitements appartenant au groupe comprenant :
- réduction du débit de signaux en son ;
- réduction du débit de signaux d'images fixes et/ou animées ;
- conversion de format de signaux d'images ou de sons ;
- changement de représentation de signaux ;
- multiplexage/démultiplexage de signaux ;
- traitement de signaux radar ;
- filtrage de signaux multidimensionnels.

## Patentansprüche

1. Filterungsverfahren eines digitalen Quellsignals (x(s)), das nach Unterbändern zerlegt ist, welches eine Definitionsphase der Filterung und eine Filterungsphase umfaßt, wobei die Definitionsphase die folgenden Schritte umfaßt:
- Definition (155) eines globalen Filterungsprofils (156; Figuren 12 bis 14), das einer Filterung entspricht, welche auf das digitale Quellsignal (x(s)) angewandt werden soll;
- Festlegung (157) eines Satzes partieller Filterungsprofile (154₀ bis 154_{N-1}; Figuren 11 und 13) durch mindestens zwei Filterungskoeffizienten charakterisiert und jeweils mit einem der zwei Unterbänder (152₀ bis 152_{N-1}) assoziiert, wobei diese partiellen Filterungsprofile (154₀ bis 154_{N-1}) ausgehend vom globalen Filterungsprofil (156) derart festgelegt werden, daß bei einer Umkehrtransformation mindestens einige von ihnen Faltungstermen der Spektren (132₁ bis 132₃) erzeugen, welche sich mit anderen Faltungstermen kompensieren sollen, die durch andere partielle Filterungsprofile erzeugt wurden;
und wobei die Filterungsphase die folgenden Schritte umfaßt:
- Transformation (151) des Zeitbereiches in den Frequenzbereich des digitalen Quellsignals (x(s)), das mindestens zwei Unterbänder verschiedener Frequenz ergibt (152₀ bis 152_{N-1}; SB₀ bis SB₃);
- Filterung (153) eines jeden dieser Unterbänder (152₀ bis 152_{N-1}) entsprechend dem mit ihm assoziierten partiellen Filterungsprofil (154₀ bis 154_{N-1}), wobei der Filterungsschritt (153) jedem der Unterbänder (152₀ bis 152_{N-1}) ein entsprechendes gefiltertes Unterband l158₀ bis 158_{N-1}) assoziiert, das Spektralfaltungen (131₁ bis 131₃, 132₁ bis 132₃) aufweist, die sich aus der Filterung (153) gemäß dem partiellen Filterungsprofil ergeben, und
- Umkehrtransformation (159) des Transformationsschrittes (151) der gefilterten Unterbänder (158₀ bis 158_{N-1}) vom Frequenzbereich in den Zeitbereich, die ein wiederhergestelltes gefiltertes Signal (rec(s)) ergibt.

2. Verfahren gemäß Anspruch 1,
dadurch gekennzeichnet, daß der Feststellungsschritt (157) eines Satzes partieller Filterungsprofile für mindestens eines der partiellen Filterungsprofile (154₀ bis 154_{N-1}) einen Bedingungsschritt (157) der partiellen Filterungsprofile (154₀ bis 154_{N-1}) umfaßt, als Funktion von mindestens einem der benachbarten partiellen Filterungsprofile im Frequenzbereich, welches dieses partielle Filterungsprofil einem derartigen Zwang unterwirft, daß bei dem Umkehrtransformationsschritt (159) die Spektralfaltungen (132₁ bis 132₃), die nach der Filterung gemäß diesem Filterungsprofil beim Filterungsschritt (153) übrigbleiben, sich in etwa mit den Spektralfaltungen (131₁ bis 131₃) kompensieren, welche nach der Filterung gemäß dem mindestens einen benachbarten partiellen Filterungsprofil verbleiben.

3. Verfahren gemäß Anspruch 2,
dadurch gekennzeichnet, daß der Bedingungsschritt (157) auf die partiellen Filterungsprofile (154₀ bis 154_{N-1}) einen derartigen Zwang ausübt, daß das Spektrum (Figuren 12 und 14) des wiederhergestellten Signals (rec(s)) kontinuierlich ist.

4. Verfahren gemäß Anspruch 2 oder 3,
dadurch gekennzeichnet, daß der Bedingungsschritt (157) auf mindestens einen der partiellen Filterungsprofile (154₀ bis 154_{N-1}) einen derartigen Zwang ausübt, daß es Tangenten (141₁ bis 141₃) aufweist, die in der Umgebung der Positionsfrequenzen gleich 0 Modulo π in etwa horizontal sind.

5. Verfahren gemäß einem der Ansprüche 1 bis 4,
dadurch gekennzeichnet, daß die partiellen Filterungsprofile (154₀ bis 154_{N-1}) durch lineare Kombination von mindestens einem Basisfilter aus einem Satz von mindestens einem im voraus definierten Basisfilter erzeugt werden.

6. Verfahren gemäß Anspruch 5,
dadurch gekennzeichnet, daß die lineare Kombination Multiplikationskoeffizienten ins Spiel bringt, die derart festgelegt sind, daß die erhaltenen Filter ohne Multiplikation eingesetzt werden können, und zwar mit Hilfe eines Satzes binärer Additionen und Verschiebungen.

7. Verfahren gemäß einem der Ansprüche 5 oder 6,
dadurch gekennzeichnet, daß das Quellsignal ein eindimensionales Signal ist und daß mindestens eines der partiellen Filterungsprofile aus einem Basisfilter mit den folgenden Koeffizienten erhalten wird:
[0,25 * α; 0,5 * α + β; 0,25 * α], wobei α und β reelle Zahlen sind.

8. Verfahren gemäß einem der Ansprüche 5 oder 6,
dadurch gekennzeichnet, daß das Quellsignal ein zweidimensionales Signal ist und daß mindestens eines der partiellen Filterungsprofile durch Linearkombination von mindestens einem der Basisfilter mit den folgenden Koeffizienten erhalten wird:

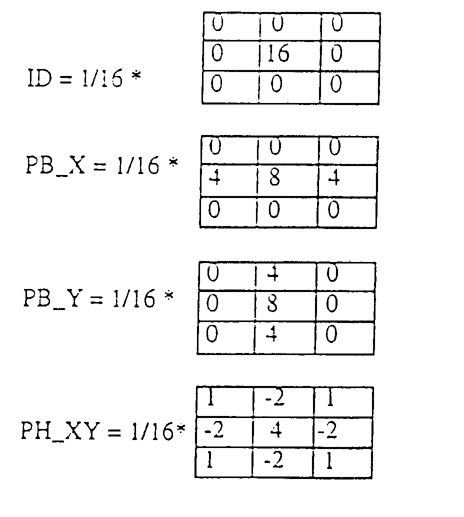

9. Verfahren gemäß einem der Ansprüche 1 bis 8,
dadurch gekennzeichnet, daß der Transformationsschritt (151) einen Anwendungsschritt (151) einer Analysenfilterbank (11) umfaßt und daß der Umkehrtransformationsschritt (159) einen Anwendungsschritt (159) einer Synthesefilterbank (15) umfaßt, wobei die Analyse- und Synthesefilter eine sehr hohe Frequenzselektivität vorweisen.

10. Filterungsvorrichtung eines digitalen Quellsignals (x(s)),
dadurch gekennzeichnet, daß sie folgendes umfaßt:
- Mittel (91) zum Transformieren des Zeitbereiches in den Frequenzbereich des digitalen Quellsignals (x(s)), die mindestens zwei Unterbänder verschiedener Frequenzen (SB₀ bis SB₃) ergeben;
- Mittel (95) zur Festlegung eines Satzes partieller Filterungsprofile (96₀ bis 96₃), die jeweils mit einem der Unterbänder (SB₀ bis SB₃) assoziiert sind, wobei diese Filterungsprofile auf der Grundlage eines globalen Filterungsprofils (98) erzeugt werden, welches einer Filterung entspricht, die auf das digitale Quellsignal (x(s)) angewandt werden soll und einem derartigen Zwang ausgesetzt wird, daß das wiederhergestellte gefilterte Signal (rec(s)) in etwa der direkten Filterung des digitalen Quellsignals (x(s)) gemäß dem globalen Filterungsprofil (98) entspricht, wobei mindestens einige dieser partiellen Profile bei der Wiederherstellung derartige spektrale Faltungsterme hervorrufen, daß diese sich mit den Spektralfaltungstermen kompensieren, die von den anderen Teilprofilen hervorgerufen werden;
- Filterungsmittel (92₀ bis 92₃) für jedes der Unterbänder (SB₀ bis SB₃) gemäß dem assoziierten partiellen Filterungsprofil (96₀ bis 96₃), wobei jedem der Unterbänder (SB₀ bis SB₃) ein entsprechendes gefiltertes Unterband (94₀ bis 94₃) assoziiert wird, und
- Mittel (93) zur Umkehrtransformation des Transformationsschrittes (91) vom Frequenzbereich in den Zeitbereich der gefilterten Unterbänder (94₀ bis 94₃), die ein wiederhergestelltes gefiltertes Signal (rec(s)) ergeben.

11. Anwendung des Filterungsverfahrens gemäß einem der Ansprüche 1 bis 9 auf eine der Anwendungen aus folgender Gruppe:
- Reduzierung des Tonsignaldurchsatzes;
- Reduzierung des Bildsignaldurchsatzes für stehende/bewegte Bilder;
- Formatkonvertierung von Bild- oder Tonsignalen;
- Änderung der Signaldarstellung;
- Multiplexieren/Entmultiplexieren von Radarsignalen;
- Bearbeitung von Radarsignalen
- Filterung mehrdimensionaler Signale.

## Claims

1. Method for filtering a source digital signal (x(s)) decomposed into sub-bands comprising a filtering definition phase and a filtering phase, said definition phase comprising the steps of:
- definition (155) of an overall filtering profile (156; Figures 12 to 14) corresponding to a filtering intended to be applied to said source digital signal (x(s));
- determination (157) of a set of partial filtering profiles (154₀ to 154_{N-1}; Figures 11 and 13) characterized by at least two filtering coefficients each associated with one of said sub-bands (152₀ to 152_{N-1}), said partial filtering profiles (154₀ to 154_{N-1}) being determined from said global filtering profile (156) in such a way that, upon reverse transformation, at least some of them generate spectral aliasing terms (132₁ to 132₃) intended to be compensated for with other spectral aliasing terms generated by other partial filtering profiles;
and said filtering phase comprising the steps of:
- transformation (151) from the temporal domain into the frequency domain of said source digital signal (x(s)), delivering at least two distinct frequency sub-bands (152₀ to 152_{N-1}; SB₀ to SB₃);
- filtering (153) of each of said sub-bands (152₀ to 152_{N-1}) according to the partial filtering profile (154₀ to 154_{N-1}) that is associated with it, said filtering step (153) accociating a corresponding filtered sub-band (158₀ to 158_{N-1}) with each of said sub-bands (152₀ to 152_{N-1}), said filtered sub-band having spectral aliasings (131, to 131₃, 132, to 132₃) due to the filtering (153) according to said filtering profile; and
- transformation (159) of said filtered sub-bands (158₀ to 158_{N-1}) in reverse to said transformation step (151), from the frequency domain into the temporal domain, delivering a reconstructed filtered signal (rec(s)).

2. Method according to Claim 1, characterized in that said step (157) for determining a set of partial filtering profiles comprises, for at least one of said partial filtering profiles (154₀ to 154_{N-1}), a step (157) for enforcing said partial filtering profile as a function of at least one of its neighbouring partial filtering profiles in the frequency domain, enforcing said partial filtering profile so that, during said reverse transformation step (159), the spectral aliasings (132₁ to 132₃) remaining after the filtering according to said filtering profile during said filtering step (153) are substantially compensated for with the spectral aliasings (131₁ to 131₃) remaining after the filtering according to said at least one neighbouring partial filtering profile.

3. Method according to Claim 2, characterized in that said enforcing step (157) enforces said partial filtering profiles (154₀ to 154_{N-1}) so that the spectrum (Figures 12 and 14) of said reconstructed signal (rec(s)) is continuous.

4. Method according to either one of Claims 2 and 3, characterized in that said enforcing step (157) enforces at least one of said partial filtering profiles (154₀ to 154_{N-1}) so that it has substantially horizontal tangents (141₁ to 141₃) in the vicinity of the frequency positions equal to 0 modulo π.

5. Method according to any one of Claims 1 to 4, characterized in that said partial filtering profiles (154₀ to 154_{N-1}) are obtained by linear combination of at least one basic filter belonging to a set of at least one predefined basic filter.

6. Method according to Claim 5, characterized in that said linear combination implements multiplier coefficients fixed so that the filters obtained can be installed without multiplication by means of a set of additions and binary shifts.

7. Method according to either one of Claims 5 and 6, characterized in that said source signal is a one-dimensional signal, and in that at least one of said partial filtering profiles is obtained by means of a basic filter having coefficients:
[0.25 * α; 0.5 * α + β; 0.25 * α], α and β being real numbers.

8. Method according to either one of Claims 5 and 6, characterized in that said source signal is a two-dimensional signal, and in that at least one of said partial filtering profiles is obtained by linear combination of at least one of the basic filters having the following coefficients:

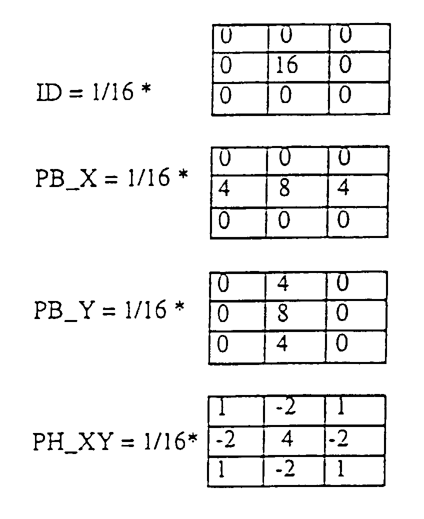

9. Method according to any one of Claims 1 to 8, characterized in that said transformation step (151) comprises a step (151) for the application of a bank of analysis filters (11) and in that said reverse transformation step (159) comprises a step (159) for the application of a bank of synthesis filters (15), said analysis and synthesis filters being filters that are highly selective in frequency.

10. Device for filtering a source digital signal (x(s)), characterized in that it comprises:
- means (91) for the transformation from the temporal domain into the frequency domain of said source digital signal (x(s)), delivering at least two distinct frequency sub-bands (SB₀ to SB₃);
- means (95) for determining a set of partial filtering profiles (96₀ to 96₃), each associated with one of said sub-bands (SB₀ to SB₃), said filtering profiles being determined from an overall filtering profile (98) corresponding to a filtering intended to be applied to said source digital signal (x(s)) and being enforced so that the reconstructed filtered signal (rec(s)) corresponds substantially to the direct filtering of said source digital signal (x(s)) according to said overall filtering profile (98), at least some of said partial profiles inducing, during reconstruction, spectral aliasing terms such that they are compensated for with the spectral aliasing terms induced by the other partial profiles; and
- means (92₀ to 92₃) for filtering each of said sub-bands (SB₀ to SB₃) according to the partial filtering profile (96₀ to 96₃) that is associated with it, associating a corresponding filtered sub-band (94₀ to 94₃) with each of said sub-bands (SB₀ to SB₃); and
- means (93) for the transformation of said filtered sub-bands (94₀ to 94₃) in reverse to said transformation step (91), from the frequency domain into the temporal domain, delivering a reconstructed filtered signal (rec(s)).

11. Application of the filtering method according to any one of Claims 1 to 9 to one of the processing operations belonging to the group comprising:
- reduction of the bit rate of sound signals;
- reduction of the bit rate of still and/or moving image signals;
- conversion of the format of image or sound signals;
- changing of the representation of signals;
- multiplexing/demultiplexing of signals;
- processing of radar signals;
- filtering of multidimensional signals.
